# EUROPEAN PATENT APPLICATION

(11) **EP 4 844 365 A1**
(43) Date of publication of application: **25.11.2026**
(21) Application number: 25178397.3
(22) Date of filing: 23.05.2025
(51) Int. Cl.: G01N 1/28, G01N 1/32, H01J 37/305

(54) **SYSTEM, METHOD, AND COMPUTER PROGRAM FOR AN ION MILLING SYSTEM, ION MILLING SYSTEM**

(71) Applicant: Leica Mikrosysteme GmbH, 1170 Wien (AT)
(72) Inventor: WINKLER, Konrad, 1170 Wien (AT); KATZENGRUBER, Matthias, 1170 Wien (AT); AOUDJIT, Slimane, 1170 Wien (AT)
(74) Representative: 2SPL Patentanwälte PartG mbB

(57) **Abstract**

Various examples of the present disclosure relate to a system (110), a method, and a computer program for an ion milling system (100), and to an ion milling system comprising such a system. The system (100) is configured to obtain image data of an optical imaging device (120) of the ion milling system, the image data showing a sample (10) to be milled using the ion milling system and a mask (30) at least partially shielding the sample, process the image data to determine, relative to the image data, at least one of a position or orientation of an edge of the mask, and store information on the position and/or orientation of the edge of the mask.

## Description

### Technical field

Various examples of the present disclosure relate to a system, a method, and a computer program for an ion milling system, and to an ion milling system comprising such a system.

### Background

In an ion mill, samples are processed using an ion beam, such as an argon ion beam, to create a flawless surface for subsequent analysis with an electron microscope. For this purpose, the sample is mounted on a sample stage opposite the ion source. In cross-sectioning mode, a mask shields a portion of the ion beam. The material of the sample that is above the mask is etched away by the ion beam, while the rest remains intact. The ion source, mask, and sample are adjusted in relation to one another so that a good result can be achieved by irradiating the sample with ions.

During target preparation, the positions of the sample, mask, and ion source are adjusted relative to each other using an optical microscope. The mask is adjusted precisely, with an accuracy in the µm range, to the sample. Generally, this involves the user viewing the mask and sample with a microscope and adjusting the portion of the sample protruding over the mask at a suitable magnification. The problem with this is that the edge of the mask, a reflection from the edge of the mask, and the sample are hard to distinguish and separate. Inexperienced users of an ion mill may have difficulty making precise adjustments.

There may be a desire to provide an improved concept for placing the mask and sample relative to each other.

### Summary

This desire is addressed by the subject matter of the independent claims.

Various examples of the present disclosure are based on the finding that digital image processing can be used to accurately detect the edges of objects shown in image data, even in cases that are difficult to perceive for untrained human eyes. In the proposed concept, digital image processing techniques, such as edge detection, contrast detection, object detection, or image segmentation, are used to identify the edge of the mask. Based on the identified edge of the mask, a digital view of the sample and the mask can be generated, with the position and orientation of the mask being highlighted in the digital view. This way, the user can more easily discern which portions of the sample are going to be removed by the ion milling (and which not), which helps less experienced users in properly aligning the sample with the mask for ion milling. Additionally, or alternatively, the position/orientation of the edge of the mask can be used to automatically process the sample, e.g., by controlling a positioning mechanism to adjust the relative positioning between mask and sample.

Some aspects of the present disclosure relate to a system for an ion milling system. The system comprises one or more processors and one or more storage devices. The system is configured to obtain image data of (e.g., from) an optical imaging device of the ion milling system. The image data shows a sample to be milled using the ion milling system and a mask at least partially shielding the sample. The system is configured to process the image data to determine, relative to the image data, at least one of a position or orientation of an edge of the mask. The system is configured to store information on the position and/or orientation of the edge of the mask. This information can subsequently be used to generate a digital view of the sample, in which the edge of the mask is highlighted, and/or for the purpose of automatic processing of the sample.

In some examples, the system may be configured to generate a digital view of the sample and the mask based on the information on the position and/or orientation of the edge of the sample. The digital view may comprise an indicator highlighting the position and/or orientation of the edge of the mask. The system may be configured to provide the digital view for (e.g., to) a display device of the ion milling system. Using the indicator included in the digital view, the user can more easily discern which portions of the sample are going to be removed by the ion milling (and which not), which helps less experienced users in properly aligning the sample with the mask for ion milling.

In ion milling, the cross-section mode is a technique where an ion beam is directed at a sample at a shallow angle to cut or polish it, creating a clean cross-sectional view of the interior structure. This allows researchers to examine the internal layers, interfaces, and features of materials that would otherwise be hidden from surface analysis. It is commonly used in materials science and semiconductor device analysis to prepare samples for examination by electron microscopy. The proposed concept can help in properly selecting where, inside the sample, the cross-sectional view is exposed, by highlighting the height of the protrusion of the sample relative to the edge of the mask. Accordingly, the digital view may illustrate the height of a protrusion of the sample relative to the edge of the mask.

To further aid the user in selecting where, inside the sample, the cross-sectional view is exposed, a scale may be shown within the digital view. In other words, the system may be configured to include a scale for determining the height of a protrusion of the sample relative to the edge of the mask in the digital view. For example, the scale may include a reference line or marker that indicates the actual size of the objects (mask, sample) being viewed. It typically appears as a straight line with measurement units (such as µm or multiples of µm), allowing the user to determine the height of the protrusion. The scale can help the user determine how far the sample protrudes over the mask, that is, how much material is removed.

In many ion mills, a microscope is provided to help the user in aligning the sample with the mask. Depending on the zoom level, the mask and sample are shown at different magnification levels. In the proposed concept, this impacts the scale that is shown for determining the height of a protrusion of the sample relative to the edge of the mask. Thus, the system may be configured to generate (e.g., scale) the scale according to the zoom level of the optical imaging device.

In some examples, it may be beneficial to not only determine the edge of the mask, but also the edge of the sample, e.g., so that the height of the protrusion can be shown as a numerical value, or to determine an angular misalignment between the edge of the mask and the edge of the sample. Thus, the system may be configured to process the image data to determine, relative to the image data, at least one of a position or orientation of an edge of the sample, and to store information on the position and/or orientation of the edge of the sample. For example, the system may be configured to generate the digital view based on the position and/or orientation of the edge of the sample of the stored information on the position and/or orientation of the edge of the sample (and, optionally, based on the stored information on the position and/or orientation of the edge of the mask). Additionally, or alternatively, the system may be configured to control a positioning mechanism based on the information on the position and/or orientation of the edge of the sample.

For example, the system may be configured to generate the digital view with an indicator highlighting the position and/or orientation of the edge of the sample. This way, the user can better assess the height and orientation of the protrusion of the sample over the edge of the mask.

In some cases, the user knows exactly the height of the sample that is to be removed, for example, from a three-dimensional model of the sample. To better guide the user, the height of the protrusion may be calculated based on the distance between the two edges and displayed as part of the digital view. For example, the system may be configured to determine a distance between the edge of the mask and the edge of the sample (based on the stored information on the position and/or orientation of the edge of the mask and the stored information on the position and/or orientation of the edge of the sample), and to store information on the distance. The system may be configured to generate the digital view with a visual representation of the information on the distance (e.g., in µm) between the edge of the mask and the edge of the sample. This way, the user is guided to align the sample and mask with µm-scale precision. Additionally, or alternatively, the system may be configured to control the positioning mechanism based on the stored information on the distance.

In the proposed concept, a calibrated optical imaging device (e.g., microscope) may be used. In this context, this means that there is a known pixel-to-distance conversion factor (e.g., at µm per pixel) for at least one zoom level of the optical imaging device, which may be used to determine the distance between two arbitrary points in the image data (at least at the zoom level for which the pixel-to-distance conversion factor, with scaling applied to the conversion factor at other zoom levels, is known). This conversion factor may be used to determine the distance between the edges of the mask and the sample. Thus, the system may be configured to determine the distance between the edge of the mask and the edge of the sample based on a pixel distance between the edge of the mask and the edge of the sample in the image data and based on a zoom level of the optical imaging device. In particular, the system may use the zoom level-dependent pixel-to-distance conversion factor to calculate the real-world distance from the pixel distance. This way, a precise height of the protrusion can be determined and shown to the user.

In the proposed concept, the position and/or orientation of an edge of the mask and, optionally, of an edge of the sample is determined. In general, the edge of the mask and edge of the sample being referred to is the edge of the mask and/or sample that is to be irradiated by the ion beam emitted by the ion emitter(s) of the ion milling device. In the image data, the edge of the mask and edge of the sample being referred to may be the respective edges of the mask and sample that are at or closest to the center of the field of view of the image data. For example, the edge of the sample and edge of the mask being referred to may be edges that are adjacent to each other, with the edge of mask being the edge defining how much material is removed from the sample (i.e., the portion of the sample protruding over this edge of the sample). While the edge of the mask generally is a straight line (in the image data), this is often not the case for the edge of the sample, which may have an irregular shape (intrinsically, or as a result of mechanical pre-processing). Thus, the edge of the sample might not be a straight line, e.g., it may comprise a plurality of sections, with changes in direction between the plurality of sections.

In some cases, there may be angular misalignment between the edge of the sample and the edge of the mask; that is, the edge of the sample may be tilted relative to the edge of the mask. This condition may be detected and brought to the attention of the user. Accordingly, the system may be configured to determine a mismatch (e.g., an angular misalignment) between the orientation of the edge of the mask and the orientation of the edge of the sample, and store information on the mismatch. As outlined above, this might not be straightforward in the case of the edge of the sample not being a straight line. In this case, the edge of the sample may be abstracted to a straight line, which may be used for the purpose of determining the mismatch. In other words, the mismatch may be determined using the orientation of a straight line abstracting the edge of the sample. For example, the system may be configured to perform automatic fitting of a straight line to the (e.g., rough sawn) edge of the sample, e.g., using the center of gravity line (centroid line) derived from the edge of the sample, or using the other edges of the sample (which may be straight lines) as reference. Alternatively, or additionally, the system may provide a user interface for the user, to let the user input or adjust a straight line that is based on the edge of the sample.

For example, the system may be configured to generate the digital view with information on the mismatch based on the information on the mismatch. Additionally, or alternatively, the system may be configured to control the positioning mechanism based on the stored information on the mismatch. This way, cases can be avoided in which the cross section is at an undesired angle.

Various types of image processing algorithms may be used to determine the respective edges. For example, the system may be configured to use at least one of image segmentation and/or object detection to determine a position of the mask and/or the sample in the image data. The system may be configured to determine the position and/or orientation of the edge of the mask and/or of the sample based on the position of the mask or sample in the image data. Machine-learning based techniques, such as image segmentation or object detection, can be adapted to complex patterns in image data, providing more accurate and reliable edge detection compared to traditional methods.

Alternatively, or additionally, the system may be configured to use an edge detection algorithm and/or a contrast detection algorithm to determine at least one edge of at least one object shown in the image data. For example, the system may be configured to use the position of the mask or sample in the image data to select the edge as the edge of the mask and/or sample. Alternatively, or additionally, the system may be configured to limit the edge detection algorithm or contrast detection algorithm to a portion of the image showing the edge of the mask and/or sample. Traditional edge detection and contrast detection techniques are computationally less intensive and faster than machine learning techniques, such as image segmentation or object detection, making them suitable for real-time applications.

The goal of the proposed concept is to help the user properly align the mask and the sample. In some examples, the alignment itself may be performed by a positioning mechanism of the ion milling system. In other words, the system may be configured to control a positioning mechanism to change a relative position between the sample and the mask based on the stored information (e.g., based on one or more of the information on the position and/or orientation of the edge of the mask, the information on the position and/or orientation of the edge of the sample, the information on the distance, and/or the information on the mismatch). For example, the change in relative position may be observable via the digital view. This way, the user may be further aided in aligning the mask and sample.

The system may not only be suitable for determining the protrusion of the sample prior to alignment, but also to monitor the result of the (manual or automatic) adjustment of the relative position. For example, the system may be configured to update the digital view after a relative position and/or orientation between the sample and the mask is adjusted by the user or by a positioning mechanism. This way, the user can verify whether the alignment has been successful.

Another aspect of the present disclosure relates to an ion milling system comprising the system, an optical imaging device and a display device.

Some aspects of the present disclosure relate to a corresponding method for an ion milling system. The method comprises obtaining image data of an optical imaging device of the ion milling system. The image data shows a sample to be milled using the ion milling system and a mask that at least partially shields the sample. The method further comprises processing the image data to determine, relative to the image data, a position and orientation of an edge of the mask. The method further comprises storing information on the position and/or orientation of the edge of the mask.

As outlined above, in some cases, a digital view may be generated. Thus, the method may further comprise generating a digital view of the sample and the mask based on the stored information on the position and/or orientation of the edge of the mask. The digital view may comprise an indicator highlighting the position and orientation of the edge of the mask. The method may comprise providing the digital view for a display device of the ion milling system.

As outlined above, the goal of the proposed concept is to help the user in properly aligning the mask and the sample. In some examples, the alignment itself may be performed by a positioning mechanism of the ion milling system. Thus, the method may comprise controlling a positioning mechanism to change a relative position between the sample and the mask. Alternatively, the method may comprise manually adjusting (e.g., changing) a relative position between the sample and the mask. In both cases, the change in relative position may be observable via the digital view. This way, the user may be further aided in aligning the mask and sample.

An aspect of the present disclosure relates to a computer program having program code for performing the above method (except for manually changing the relative position) when the program is executed on a processor.

### Short description of the Figures

Some examples of apparatuses and/or methods will be described in the following by way of example only, and with reference to the accompanying figures, in which:
- Fig. 1a: shows a schematic diagram of an example of an ion milling system during ion milling of a sample;
- Fig. 1b: shows a schematic diagram of an example of an ion milling system during observation of a sample;
- Fig. 2: shows a schematic diagram of an example of a digital view of a mask and sample;
- Fig. 3: shows a schematic diagram of an example of a sample stage with one or more positioning mechanisms;
- Fig. 4: shows a flowchart of an example of a method for an ion milling system; and
- Fig. 5: shows a schematic diagram of an example of a system comprising an optical imaging device and a computer system.

### Detailed Description

Various examples will now be described more fully with reference to the accompanying drawings in which some examples are illustrated. In the figures, the thicknesses of lines, layers and/or regions may be exaggerated for clarity.

The present disclosure relates to ion milling. Ion milling is a technique used to etch or clean the surface of materials using a beam of ions that is emitted by an ion source, such as an argon ion source. Ion milling works by directing a high-energy beam of ions at the surface of a sample. As these ions collide with the atoms at the surface of the material, they effectively sputter away the atoms, gradually eroding the surface. This process is known for its precision and is commonly used in scenarios where traditional mechanical or chemical methods might be too harsh or imprecise.

The technique is widely utilized in the preparation of samples for electron microscopy, where a clean, smooth surface is crucial for accurate imaging. It is also employed in the microelectronics industry for thinning semiconductor samples, enabling detailed analysis. Additionally, ion milling is used in materials science research, where understanding the composition and structure of materials at the microscopic level is beneficial.

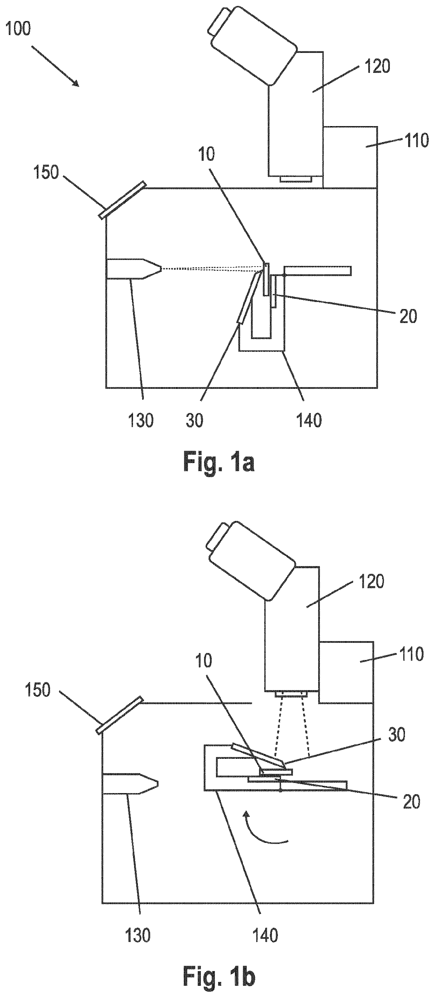

Fig. 1a shows a schematic diagram of an example of an ion milling system 100 during ion milling of a sample 10. An ion milling system 100 typically comprises several components. These include at least one ion emitter 130, which comprises the ion source that generates the ion beam (commonly using Argon gas) and ion optics, which are used to direct the beam onto the sample 10. An ion beam positioning system (not shown) may be used to target the sample by adjusting at least one of a lateral position, vertical position, or orientation of the at least one ion emitter 130.

A sample stage 140 holds and precisely positions the sample during processing. The sample 10 is attached to a sample holder 20, which is mounted to the sample stage 140. A mask 30 partially shields the sample 10 during ion milling. A sample stage positioning system (not shown) may be used to position the sample stage 140 with the sample 10 relative to the ion beam, e.g., by adjusting at least one of a lateral position, vertical position, or orientation of the sample stage 140, and therefore of the sample 10. The ion milling system 100 may also use vacuum equipment to maintain a controlled environment, which is useful for reducing or minimizing contamination and ensuring consistent results. Finally, a control system 110 controls the operation and parameters of the ion milling process, allowing for adjustments to be made for different applications and material types. The control system 110 can be controlled via a touch-screen display 150, which is coupled to the control system 110.

In the ion milling system 100 shown in Figs. 1a and 1b, a digital or hybrid microscope 120 allows a user to inspect the sample 10 that is placed on the sample stage 140. The control system 110 uses image data from the microscope 120, which performs the function of an imaging device. Alternatively, a camera (not shown) may be placed in the chamber of the ion milling system 100 and used to monitor the sample before and after the ion milling. As the sputtering leads to deposition of material removed from the sample on the components inside the ion milling chamber, the camera may be shielded from the sample chamber during ion milling, for example, using a retractable shield, which may be removed periodically or occasionally to allow for monitoring of the progress of the ion milling process.

The proposed concept relates to a mechanism for assisting the user in aligning the mask and sample. In the cross-sectioning mode of the ion milling system 100, the mask 30 shields part of the sample 10 from the ion beam. The material of the sample that is above the mask is etched away by the ion beam, while the rest remains intact. The ion source, mask, and sample are adjusted in relation to one another so that a satisfactory result can be achieved by irradiating the sample with ions. The proposed concept supports this alignment by providing a digital view that helps the user align the mask and sample. In this context, the terms alignment and aligning do not mean that the edges of the mask and sample are aligned with each other. On the contrary, in the present context, aligning the mask and sample has the goal of ensuring that a desired height of the sample (i.e., the portion of the sample that is being removed by ion milling) protrudes (in a straight manner) over the edge of the mask.

The proposed concept is based on providing a digital view of the sample and mask to the user. For this purpose, the system 110 is configured to obtain image data of an optical imaging device (e.g., the microscope 120 or the camera) of the ion milling system. The image data shows the sample 10 to be milled using the ion milling system and the mask 30 that is at least partially shielding the sample. In particular, the image data shows the sample 10 and mask 30 from the ion emitter-facing side (at least when the sample stage 140 is in a configuration, as shown in Fig. 1a, facing the ion emitter 130), allowing discernment of how much of the sample protrudes over the mask edge. The system 110 then processes the image data to determine, relative to the image data, at least one of the position or orientation of an edge of the mask. In this context, the position of the edge of the mask may comprise the pixel position of at least one pixel showing the edge of the mask inside the image data. In some cases, the position of the edge of the mask may comprise the pixel position of at least two pixels showing the edge of the mask, allowing the determination of a straight line representing the edge of the mask. Accordingly, the orientation of the edge of the mask may comprise the pixel position of at least two pixels showing the edge of the mask, or a vector representing a straight line showing the orientation of the edge of the mask relative to the image data.

To determine the position and orientation of the edge of the mask (and sample) in the image data, various types of image processing algorithms may be used. For example, the system 110 may be configured to use image segmentation and/or object detection to determine a position of the mask and/or the sample in the image data, and to determine the position and/or orientation of the edge of the mask and/or of the sample based on the position of the mask or sample in the image data. In particular, the system 110 may be configured to use object detection to identify the position of a pre-defined object (e.g., the mask 30, or the sample 10) by locating it within an image via bounding boxes, which provide coordinates (x, y, width, height). This way, the system 110 can distinguish between portions of the image that show the mask 30 versus portions of the image that show the sample 10. Then, the system 110 may use image segmentation to determine the exact position of the respective edges. Image segmentation, particularly instance segmentation, delineates the precise boundaries of the mask (and sample) at the pixel level. For example, the positions of the pixels at the edge of the mask (as segmented using image segmentation) may be used as the position(s) of the edge of the mask. For example, the system 110 may be configured to process the boundaries of the mask (and sample) identified using image segmentation to determine the principal axis of the edge of the mask 30 (or sample 10), and to determine the orientation of the mask 30 (or sample 10) based on the principal axis of the edge of the mask 30 (or sample 10).

Both object detection and image segmentation are performed by processing the image data using a machine learning model. This machine learning model may be trained, for example, using supervised learning, to perform the respective tasks. For example, the respective machine learning model may be trained with a plurality of training samples, with each training sample including image data as input and a desired output (bounding box(es) of object(s) of interest, such as mask and sample), or segmentation mask for mask and/or sample.

Additionally, or alternatively, classical image processing algorithms, such as edge detection and/or contrast detection, may be used to determine the position and/or orientation of the mask 30 (and/or sample 10) in the image data. In other words, the system may be configured to use an edge detection algorithm and/or a contrast detection algorithm to determine at least one edge of at least one object shown in the image data. For example, the edge detection algorithm (e.g., the Sobel or Canny edge detection algorithm) may be used to identify intensity gradients in the image data, thus identifying boundaries of objects. For a pre-defined object like a mask or sample, the edges are detected, and features (e.g., lines, corners) may be analyzed to locate the position (e.g., as coordinates) and orientation (e.g., as angle) of the respective edge. The contrast detection algorithm (e.g., a thresholding-based contrast algorithm or a gradient magnitude-based contrast detection algorithm) may be used to isolate regions with distinct intensity differences, enabling segmentation of the objects from each other and the background. Once the object's contour is identified, geometric fitting may be used to determine the position and orientation of the edges along the contour of the object. The determined edges may then be associated with the respective objects (mask and sample). Thus, the position of the mask or sample in the image data (e.g., provided by the object detection algorithm or selected by the user) may be used to select the edge as edge of the mask or sample (and/or the edge as edge of the sample). Alternatively, the known position of the mask or sample in the image data may be used to limit the edge detection algorithm or contrast detection algorithm to a portion of the image showing the edge of the mask or sample.

This information (position and/or orientation of the mask's edge) is then stored (e.g., in a memory (memory circuitry) or storage (storage circuitry), such as one or more storage devices of the system 110) and can then be used for various downstream tasks. For example, the information on the position and/or orientation of the edge of the mask can be used to highlight the edge of the mask in a digital view of the mask and sample. In other words, the system 110 may be configured to generate a digital view 40 of the sample 10 and the mask 30 based on the stored information. This digital view may be based on the image data; for example, it may use the image data as a background or upper layer. In addition to the image data, an overlay may be provided to highlight the position/orientation of at least the edge of the mask. In other words, the digital view comprises an indicator 50 highlighting the position and/or orientation of the edge of the mask. For example, the edge of the mask may be highlighted using a black, white, or colored and solid, dashed, or dotted line 50 tracing the edge of the mask. This indicator may be generated based on the position(s) of the edge of the mask (e.g., by tracing a straight line through at least two positions) and/or based on the orientation (e.g., by using the orientation of the edge of the mask to draw the indicator). **The** height of the portion of the sample that protrudes over the edge of the mask-that is, the portion of the sample that will be removed using ion milling-is clearly discernible next to such an indicator. In other words, the digital view illustrates the height of a protrusion of the sample relative to the edge of the mask.

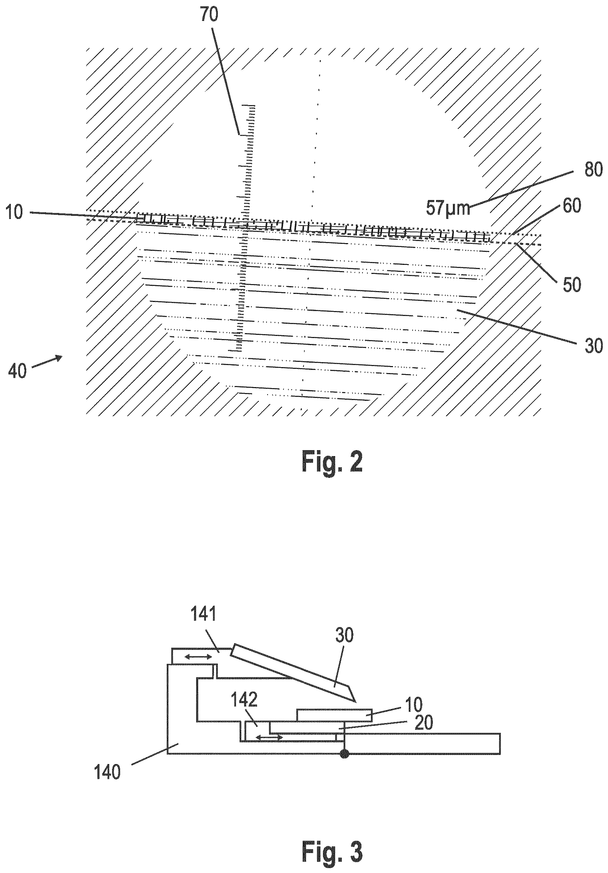

In Fig. 2, the use of a straight line 50 as an indicator for highlighting the position and/or orientation of the edge of the mask is shown. Fig. 2 shows a schematic diagram of an example of a digital view on a mask 30 and sample 10. In Fig. 2, on the bottom of the circular digital view provided by the microscope, the mask 30 is shown. The edge of the mask is indicated by a dashed line 50. A portion of the sample 10 protrudes over the edge of the mask 30. The edge of the sample 10 is indicated by a dotted line 60, which is also generated by the system 110. Thus, the system 110 may be configured to process the image data to determine, relative to the image data, at least one of a position or orientation of the edge of the sample (e.g., similar to the determination of the edge of the mask 30), and store information on the position and/or orientation of the edge of the sample. The digital view may then be generated based on the stored information on the position and/or orientation of the edge of the sample. In particular, the system 110 may be configured to generate the digital view with an indicator 60 highlighting the position and/or orientation of the edge of the sample. For example, the edge of the sample may be highlighted using a black, white, or colored and solid, dashed, or dotted line 60 tracing the edge of the mask. For example, different line patterns (solid, dashed, or dotted) and/or colors may be used for the indicators of the edge of the mask and the edge of the sample.

Another guide that can be provided to the user is a scale that lets the user determine the height of the protrusion. For example, as shown in Fig, 2, the system 110- may be configured to include a scale 70 for determining the height of a protrusion of the sample relative to the edge of the mask in the digital view. This scale is dependent on the zoom level of the microscope, as the size of the objects appears differently at different zoom levels. Accordingly, the system may be configured to generate the scale (and in particular determine the distance of the measurement units) according to the zoom level of the optical imaging device 120.

As is evident from Fig. 2, in some cases, the edge of the mask (as well as the sample) may be tilted relative to the field of view of the optical imaging device 120. In such cases, the scale may be tilted as well, aligning with the tilt of the edge of the mask. As the tilt of the edge of the mask is indicated by the orientation of the edge of the mask, the system 110 may be configured to tilt (i.e., orient) the scale according to the orientation of the edge of the mask, such that the scale is oriented perpendicular to the edge of the mask. For example, the zero point of the measurement units of the scale may be placed at the edge of the mask.

In some examples, in particular when the system not only determines the position and/or orientation of the edge of the mask, but also of the edge of the sample, a quantitative measure of the height of the protrusion (quantitative measure 80 in Fig. 2) may also be determined, e.g., to be provided as part of the digital view. In other words, the system 110 may be configured to determine a distance (or multiple distances) between the edge of the mask 30 and the edge of the sample 10, and store information on the distance. The system 110 may be configured to generate the digital view with a visual representation of the stored information on the distance between the edge of the mask and the edge of the sample (quantitative measure 80 in Fig. 2), i.e., the height of the protrusion. For example, the height of the protrusion (information on the distance between the edge of the mask and the edge of the sample) may be expressed in µm. In case the height of the protrusion varies over the length of the sample, an average or median value may be provided for the height of the protrusion. For example, similar to the scale, the distance (or distances) may be determined with respect to an axis that is perpendicular to the edge of the mask 30, e.g., based on the orientation of the edge of the mask.

To determine the exact height of the protrusion, a known conversion factor between pixels of the image data and a distance (at a given zoom factor) may be used. In particular, the optical imaging device 120 may be a calibrated optical imaging device (e.g., microscope) with a known pixel-to-distance conversion factor (e.g., µm per pixel) for at least one zoom level of the optical imaging device. This conversion factor may be used to determine the distance between the two edges. Thus, the system 110 may be configured to determine the distance between the edge of the mask and the edge of the sample based on a pixel distance between the edge of the mask and the edge of the sample in the image data and based on a zoom level of the optical imaging device, with the zoom level indicating the pixel-to-distance conversion factor.

In some cases, the orientation of the edge of the mask 30 and the edge of the sample 10 may be different, resulting in a (small) angular deviation from the two edges being parallel.

In such cases, the user may be alerted to the angular deviation. For example, the system 110 may be configured to determine a mismatch between the orientation of the edge of the mask and the orientation of the edge of the sample (resulting in an angular deviation between the two edges), and store information on the mismatch. For example, the system may be configured to generate the digital view with information on the mismatch, e.g., if the mismatch is larger than 0.1 degrees (or larger than 0.2 degrees, or larger than 0.5 degrees, or larger than 1 degree). For example, the digital view may be provided with quantitative information (e.g., the angle) on the mismatch, e.g., the angle of the angular deviation.

The resulting digital view may then be provided for a display device 150 (e.g., for a touch screen display 150) of the ion milling system 100. To support the user during the adjustment of the relative position, the digital view may be updated, e.g., periodically (e.g., at every frame or every n-th frame) or when an update is detected in the image data. For example, the system 110 may be configured to update the digital view after a relative position and/or orientation between the sample and the mask is adjusted by the user (or by a positioning mechanism).

For example, the system 110 may be configured to provide a user interface with the digital view for the user. For example, the system 110 may be configured to output the display signal to a touch-screen display 150 or a display 150 of the ion milling system 100, with the display signal comprising the digital view. For example, the display signal may be a signal for driving (e.g., controlling) the respective display. For example, the display signal may comprise video data and/or control instructions for driving the display. For example, the display signal may be provided via one of the one or more interfaces of the system 110. Accordingly, the system 110 may comprise a video interface that is suitable for providing the display signal to the display device 150 of the ion milling system 100.

The proposed concept may be implemented as a software support tool and may be used to help in performing an adjustment of the sample protrusion over the mask. In the proposed concept, the mask edge of the ion mill is recognized, for example by software, and displayed in the image for quick and clear positioning of the sample protrusion above the mask. As is evident from Fig. 2, it is difficult to separate the mask 30 from the sample edge 10 in the image. For example, the software support tool may recognize the mask edge and symbolize it with a line so that the user always has the mask edge in view during adjustment and can easily identify it. To help the user, the mask edge may be shown with a (solid, dashed, or dotted) bar 50 in the image (e.g., in orange color). The sample edge may be shown with a (solid, dashed, or dotted) colored (e.g., green) line. In addition, the tool may show the protrusion of the sample above the mask (e.g., in µm) during adjustment. **The** mask protrusion may be shown by a number in µm. As an alternative to, or in addition to, displaying the mask protrusion in µm, a calibrated scale 70 can also be displayed (µm). This approach allows inexperienced users to adjust the sample and mask quickly and precisely, thereby increasing the precision and success rate of the experiments.

In some examples, the proposed concept may go even further and perform the adjustment without requiring manual action by the user. For example, the system 110 may be configured to control a positioning mechanism 141, 142 (shown in Fig. 3) to change a relative position between the sample and the mask based on the stored information (e.g., based on one or more of the information on the position and/or orientation of the mask, the information on the position and/or orientation of the sample, the information on the distance, and/or the information on the mismatch). For example, the system may control the positioning mechanism to adjust the relative position and/or orientation between the edge of the mask and the edge of the sample to a desired relative position (e.g., to achieve a desired distance/protrusion) and/or to a desired relative orientation (e.g., to eliminate an angular mismatch). This change in relative position is observable via the digital view. For example, as shown in Fig. 3, the sample stage 140 may be provided with at least one positioning mechanism 141, 142. Fig. 3 shows a schematic diagram of an example of a sample stage 140 with one or more positioning mechanisms 141, 142. In Fig. 3, the sample stage 140 comprises a first positioning mechanism 141 for adjusting a relative position and/or angle between the sample stage and the mask 30. For example, the first positioning mechanism may comprise a portion 141 of the sample stage that holds the mask 30 and that is movable relative to a body of the sample stage 140. This portion 141 may be moved by a servo motor, e.g., on a rail. In some examples, the portion 141 may also be rotated around an axis of rotation to adjust the orientation of the mask 30 relative to the sample 10. **The** sample stage 140 of Fig. 3 further comprises a second positioning mechanism 142 to adjust a relative position and/or angle between the sample stage and the sample 10. For example, the second positioning mechanism may comprise a portion 142 of the sample stage that holds the sample 10 and that is movable relative to a body of the sample stage 140. This portion 142 may be moved by a servo motor, e.g., on a rail. In some examples, the portion 142 may also be rotated around an axis of rotation to adjust the orientation of the sample 10 relative to the mask 30. For example, the first and second positioning mechanism 141, 142 may both be included in the sample stage, or the sample stage may comprise either of the first or second positioning mechanisms 141, 142.

In general, the system 110 may be a computer system. The system 110 comprises one or more processors and one or more storage devices. Optionally, the system 110 further comprises one or more interfaces. The one or more processors are coupled to the one or more storage devices and to the one or more interfaces. In general, the functionality of the system 110 may be provided by the one or more processors, in conjunction with the one or more interfaces (for exchanging data/information with one or more other components of the ion milling system 100 and outside the ion milling system 100, such as the optical imaging device 120, the ion emitter 130, the positioning device(s) 141, 142 and/or the touch-screen display 150), and with the one or more storage devices (for storing information, such as machine-readable instructions of a computer program being executed by the one or more processors). In general, the functionality of the one or more processors may be implemented by the one or more processors executing machine-readable instructions. Accordingly, any feature ascribed to the one or more processors may be defined by one or more instructions of a plurality of machine-readable instructions. The system 110 may comprise the machine-readable instructions, e.g., within the one or more storage devices.

In the proposed ion milling system 100, optical imaging sensor(s) of the optical imaging device 120 (e.g., the microscope 120 or the camera) are used to provide the aforementioned image data. Accordingly, the optical imaging sensor(s), which may be part of the optical imaging device 120 (e.g., of the microscope or camera), may be configured to generate the image data. For example, the optical imaging sensor(s) of the optical imaging device 120 or camera may comprise or be an APS (Active Pixel Sensor)-based imaging sensor or a CCD (Charge-Coupled-Device)-based imaging sensor. For example, in APS-based imaging sensors, light is recorded at each pixel using a photodetector and an active amplifier of the pixel. APS-based imaging sensors are often based on CMOS (Complementary Metal-Oxide-Semiconductor) or S-CMOS (Scientific CMOS) technology. In CCD-based imaging sensors, incoming photons are converted into electron charges at a semiconductor-oxide interface, which are subsequently moved between capacitive bins in the imaging sensor by circuitry of the imaging sensor to perform the imaging. For example, the system 110 may be configured to obtain the image data from the optical imaging device 120, for instance, by receiving the image data from the optical imaging device 120 or by reading out the image data from the optical imaging device 120.

The one or more interfaces of the system 110 may correspond to one or more inputs and/or outputs for receiving and/or transmitting information, which may be in digital (bit) values according to a specified code, within a module, between modules, or between modules of different entities. For example, the one or more interfaces may comprise interface circuitry configured to receive and/or transmit information. The one or more processors of the system 110 may be implemented using one or more processing units, one or more processing devices, or any means for processing, such as a processor, a computer, or a programmable hardware component operable with accordingly adapted software. In other words, the described function of the one or more processors may also be implemented in software, which is then executed on one or more programmable hardware components. Such hardware components may comprise a general-purpose processor, a Digital Signal Processor (DSP), a micro-controller, etc. The one or more storage devices of the system 110 may comprise at least one element of the group of a computer-readable storage medium, such as a magnetic or optical storage medium, e.g., a hard disk drive, a flash memory, a Floppy-Disk, Random Access Memory (RAM), Programmable Read Only Memory (PROM), Erasable Programmable Read Only Memory (EPROM), an Electronically Erasable Programmable Read Only Memory (EEPROM), or a network storage.

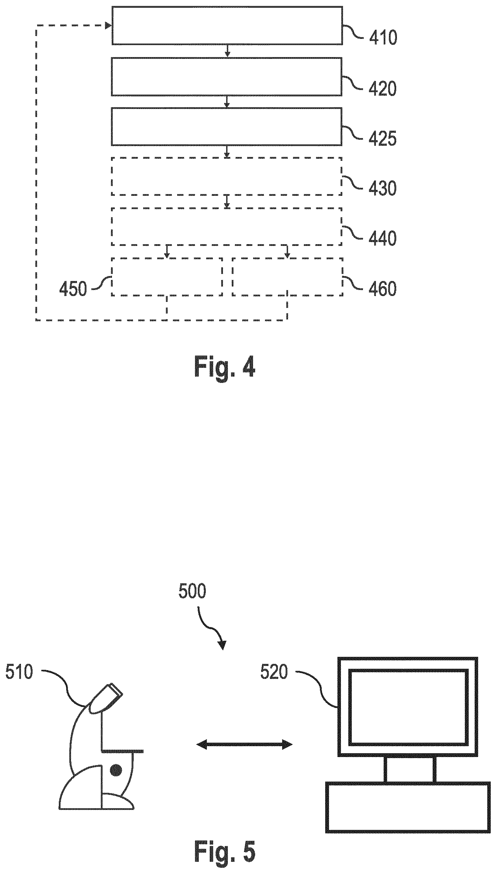

More details and aspects of the ion milling system 100 and the system 110 are mentioned in connection with the proposed concept or one or more examples described above or below (e.g., Figs. 4 to 5). The ion milling system 100 and the system 110 may comprise one or more additional optional features corresponding to one or more aspects of the proposed concept or one or more examples described above or below.

Fig. 4 shows a flowchart of an example of a method for an ion milling system, e.g., for the ion milling system 100 of Figs. 1a or 3. Features discussed in connection with the system 110 and/or ion milling system 100 of Figs. 1a to 1 may likewise be included in the corresponding method of Fig. 4.

The method comprises obtaining 410 image data of an optical imaging device of the ion milling system. The image data shows a sample to be milled using the ion milling system and a mask at least partially shielding the sample. The method comprises processing 420 the image data to determine, relative to the image data, a position and orientation of an edge of the mask. The method comprises storing 425 information on the position and/or orientation of the edge of the mask. Optionally, the method comprises generating 430 a digital view of the sample and the mask. The digital view may comprise an indicator highlighting the position and orientation of the edge of the mask. The method may comprise providing 440 the digital view for a display device of the ion milling system. Optionally, the method further comprises controlling 450 a positioning mechanism 141, 142 (of the ion milling system 100 / sample stage 140) to change a relative position between the sample and the mask. Alternatively, the method may further comprise manually changing 460 the relative position between the sample and the mask. In both cases, the change in relative position may be observable via the digital view.

More details and aspects of the method are mentioned in connection with the proposed concept or one or more examples described above or below (e.g., Figs. 1a to 3, and 5). The method may comprise one or more additional optional features corresponding to one or more aspects of the proposed concept or one or more examples described above or below.

As used herein the term "and/or" includes any and all combinations of one or more of the associated listed items and may be abbreviated as "/".

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Some embodiments relate to an optical imaging device that is part of or connected to a system as described in connection with one or more of the Figs. 1a to 4. Fig. 5 shows a schematic illustration of a system 500 configured to perform a method described herein. The system 500 comprises an optical imaging device 510, such as digital or hybrid microscope, and a computer system 520. The optical imaging device 510 is configured to take images and is connected to the computer system 520. The computer system 520 is configured to execute at least a part of a method described herein. The computer system 520 may be configured to execute a machine learning algorithm. The computer system 520 and optical imaging device 510 may be separate entities but can also be integrated together in one common housing. The computer system 520 may be part of a central processing system of the optical imaging device 510 and/or the computer system 520 may be part of a subcomponent of the optical imaging device 510, such as a sensor, an actor, a camera or an illumination unit, etc. of the optical imaging device 510.

The computer system 520 may be a local computer device (e.g. personal computer, laptop, tablet computer or mobile phone) with one or more processors and one or more storage devices or may be a distributed computer system (e.g. a cloud computing system with one or more processors and one or more storage devices distributed at various locations, for example, at a local client and/or one or more remote server farms and/or data centers). The computer system 520 may comprise any circuit or combination of circuits. In one embodiment, the computer system 520 may include one or more processors which can be of any type. As used herein, processor may mean any type of computational circuit, such as but not limited to a microprocessor, a microcontroller, a complex instruction set computing (CISC) microprocessor, a reduced instruction set computing (RISC) microprocessor, a very long instruction word (VLIW) microprocessor, a graphics processor, a digital signal processor (DSP), multiple core processor, a field programmable gate array (FPGA), for example, of a optical imaging device or a optical imaging device component (e.g. camera) or any other type of processor or processing circuit. Other types of circuits that may be included in the computer system 520 may be a custom circuit, an application-specific integrated circuit (ASIC), or the like, such as, for example, one or more circuits (such as a communication circuit) for use in wireless devices like mobile telephones, tablet computers, laptop computers, two-way radios, and similar electronic systems. The computer system 520 may include one or more storage devices, which may include one or more memory elements suitable to the particular application, such as a main memory in the form of random access memory (RAM), one or more hard drives, and/or one or more drives that handle removable media such as compact disks (CD), flash memory cards, digital video disk (DVD), and the like. The computer system 520 may also include a display device, one or more speakers, and a keyboard and/or controller, which can include a mouse, trackball, touch screen, voice-recognition device, or any other device that permits a system user to input information into and receive information from the computer system 520.

Some or all of the method steps may be executed by (or using) a hardware apparatus, like for example, a processor, a microprocessor, a programmable computer or an electronic circuit. In some embodiments, some one or more of the most important method steps may be executed by such an apparatus.

Depending on certain implementation requirements, embodiments of the invention can be implemented in hardware or in software. The implementation can be performed using a non-transitory storage medium such as a digital storage medium, for example a floppy disc, a DVD, a Blu-Ray, a CD, a ROM, a PROM, and EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may, for example, be stored on a machine readable carrier.

Other embodiments comprise the computer program for performing one of the methods described herein, stored on a machine readable carrier.

In other words, an embodiment of the present invention is, therefore, a computer program having a program code for performing one of the methods described herein, when the computer program runs on a computer.

A further embodiment of the present invention is, therefore, a storage medium (or a data carrier, or a computer-readable medium) comprising, stored thereon, the computer program for performing one of the methods described herein when it is performed by a processor. The data carrier, the digital storage medium or the recorded medium are typically tangible and/or non-transitionary. A further embodiment of the present invention is an apparatus as described herein comprising a processor and the storage medium.

A further embodiment of the invention is, therefore, a data stream or a sequence of signals representing the computer program for performing one of the methods described herein. The data stream or the sequence of signals may, for example, be configured to be transferred via a data communication connection, for example, via the internet.

A further embodiment comprises a processing means, for example, a computer or a programmable logic device, configured to, or adapted to, perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example, a field programmable gate array) may be used to perform some or all the functionalities of the methods described herein. In some embodiments, a field programmable gate array may cooperate with a microprocessor to perform one of the methods described herein. Generally, the methods are preferably performed by any hardware apparatus.

Embodiments may be based on using a machine-learning model or machine-learning algorithm. Machine learning may refer to algorithms and statistical models that computer systems may use to perform a specific task without using explicit instructions, instead relying on models and inference. For example, in machine-learning, instead of a rule-based transformation of data, a transformation of data may be used, that is inferred from an analysis of historical and/or training data. For example, the content of images may be analyzed using a machine-learning model or using a machine-learning algorithm. In order for the machine-learning model to analyze the content of an image, the machine-learning model may be trained using training images as input and training content information as output. By training the machine-learning model with a large number of training images and/or training sequences (e.g. words or sentences) and associated training content information (e.g. labels or annotations), the machine-learning model "learns" to recognize the content of the images, so the content of images that are not included in the training data can be recognized using the machine-learning model. The same principle may be used for other kinds of sensor data as well: By training a machine-learning model using training sensor data and a desired output, the machine-learning model "learns" a transformation between the sensor data and the output, which can be used to provide an output based on non-training sensor data provided to the machine-learning model. The provided data (e.g. sensor data, meta data and/or image data) may be preprocessed to obtain a feature vector, which is used as input to the machine-learning model.

Machine-learning models may be trained using training input data. The examples specified above use a training method called "supervised learning". In supervised learning, the machine-learning model is trained using a plurality of training samples, wherein each sample may comprise a plurality of input data values, and a plurality of desired output values, i.e. each training sample is associated with a desired output value. By specifying both training samples and desired output values, the machine-learning model "learns" which output value to provide based on an input sample that is similar to the samples provided during the training. Apart from supervised learning, semi-supervised learning may be used. In semi-supervised learning, some of the training samples lack a corresponding desired output value.

Supervised learning may be based on a supervised learning algorithm (e.g. a classification algorithm, a regression algorithm or a similarity learning algorithm. Classification algorithms may be used when the outputs are restricted to a limited set of values (categorical variables), i.e. the input is classified to one of the limited set of values. Regression algorithms may be used when the outputs may have any numerical value (within a range). Similarity learning algorithms may be similar to both classification and regression algorithms but are based on learning from examples using a similarity function that measures how similar or related two objects are. Apart from supervised or semi-supervised learning, unsupervised learning may be used to train the machine-learning model. In unsupervised learning, (only) input data might be supplied and an unsupervised learning algorithm may be used to find structure in the input data (e.g. by grouping or clustering the input data, finding commonalities in the data). Clustering is the assignment of input data comprising a plurality of input values into subsets (clusters) so that input values within the same cluster are similar according to one or more (pre-defined) similarity criteria, while being dissimilar to input values that are included in other clusters.

Reinforcement learning is a third group of machine-learning algorithms. In other words, reinforcement learning may be used to train the machine-learning model. In reinforcement learning, one or more software actors (called "software agents") are trained to take actions in an environment. Based on the taken actions, a reward is calculated. Reinforcement learning is based on training the one or more software agents to choose the actions such, that the cumulative reward is increased, leading to software agents that become better at the task they are given (as evidenced by increasing rewards).

Furthermore, some techniques may be applied to some of the machine-learning algorithms. For example, feature learning may be used. In other words, the machine-learning model may at least partially be trained using feature learning, and/or the machine-learning algorithm may comprise a feature learning component. Feature learning algorithms, which may be called representation learning algorithms, may preserve the information in their input but also transform it in a way that makes it useful, often as a pre-processing step before performing classification or predictions. Feature learning may be based on principal components analysis or cluster analysis, for example.

In some examples, anomaly detection (i.e. outlier detection) may be used, which is aimed at providing an identification of input values that raise suspicions by differing significantly from the majority of input or training data. In other words, the machine-learning model may at least partially be trained using anomaly detection, and/or the machine-learning algorithm may comprise an anomaly detection component.

In some examples, the machine-learning algorithm may use a decision tree as a predictive model. In other words, the machine-learning model may be based on a decision tree. In a decision tree, observations about an item (e.g. a set of input values) may be represented by the branches of the decision tree, and an output value corresponding to the item may be represented by the leaves of the decision tree. Decision trees may support both discrete values and continuous values as output values. If discrete values are used, the decision tree may be denoted a classification tree, if continuous values are used, the decision tree may be denoted a regression tree.

Association rules are a further technique that may be used in machine-learning algorithms. In other words, the machine-learning model may be based on one or more association rules. Association rules are created by identifying relationships between variables in large amounts of data. The machine-learning algorithm may identify and/or utilize one or more relational rules that represent the knowledge that is derived from the data. The rules may e.g. be used to store, manipulate or apply the knowledge.

Machine-learning algorithms are usually based on a machine-learning model. In other words, the term "machine-learning algorithm" may denote a set of instructions that may be used to create, train or use a machine-learning model. The term "machine-learning model" may denote a data structure and/or set of rules that represents the learned knowledge (e.g. based on the training performed by the machine-learning algorithm). In embodiments, the usage of a machine-learning algorithm may imply the usage of an underlying machine-learning model (or of a plurality of underlying machine-learning models). The usage of a machine-learning model may imply that the machine-learning model and/or the data structure/set of rules that is the machine-learning model is trained by a machine-learning algorithm.

For example, the machine-learning model may be an artificial neural network (ANN). ANNs are systems that are inspired by biological neural networks, such as can be found in a retina or a brain. ANNs comprise a plurality of interconnected nodes and a plurality of connections, so-called edges, between the nodes. There are usually three types of nodes, input nodes that receiving input values, hidden nodes that are (only) connected to other nodes, and output nodes that provide output values. Each node may represent an artificial neuron. Each edge may transmit information, from one node to another. The output of a node may be defined as a (non-linear) function of its inputs (e.g. of the sum of its inputs). The inputs of a node may be used in the function based on a "weight" of the edge or of the node that provides the input. The weight of nodes and/or of edges may be adjusted in the learning process. In other words, the training of an artificial neural network may comprise adjusting the weights of the nodes and/or edges of the artificial neural network, i.e. to achieve a desired output for a given input.

Alternatively, the machine-learning model may be a support vector machine, a random forest model or a gradient boosting model. Support vector machines (i.e. support vector networks) are supervised learning models with associated learning algorithms that may be used to analyze data (e.g. in classification or regression analysis). Support vector machines may be trained by providing an input with a plurality of training input values that belong to one of two categories. The support vector machine may be trained to assign a new input value to one of the two categories. Alternatively, the machine-learning model may be a Bayesian network, which is a probabilistic directed acyclic graphical model. A Bayesian network may represent a set of random variables and their conditional dependencies using a directed acyclic graph. Alternatively, the machine-learning model may be based on a genetic algorithm, which is a search algorithm and heuristic technique that mimics the process of natural selection.

### List of reference Signs

- 10: Sample
- 20: Sample holder
- 30: Mask
- 40: Digital view
- 50: Indicator for edge of the mask
- 60: Indicator for edge of the sample
- 70: Scale
- 80: Quantitative measure of height of the protrusion
- 100: Ion milling system
- 110: System
- 120: Optical imaging device, microscope
- 130: Ion emitter
- 140: Sample stage
- 141: Positioning mechanism
- 142: Positioning mechanism
- 150: Touch-screen display
- 410: Obtaining image data
- 420: Processing the image data to determine a position/orientation of an edge of a mask
- 425: Storing information on the position and/or orientation of the edge of the mask
- 430: Generating a digital view
- 440: Providing the digital view
- 450: Controlling a positioning mechanism
- 460: Manually changing a relative position between sample and mask
- 500: System
- 510: Optical imaging device
- 520: Computer system

## Claims

1. A system (110, 520) for an ion milling system (100), the system comprising one or more processors and one or more storage devices, wherein the system is configured to:
obtain image data of an optical imaging device (120, 510) of the ion milling system, the image data showing a sample (10) to be milled using the ion milling system and a mask (30) at least partially shielding the sample;
process the image data to determine, relative to the image data, at least one of a position or orientation of an edge of the mask; and
store information on the position and/or orientation of the edge of the mask.

2. The system according to claim 1, wherein the system is configured to generate a digital view (40) of the sample and the mask based on the information on the position and/or orientation of the edge of the mask, the digital view comprising an indicator (50) highlighting the position and/or orientation of the edge of the mask; and provide the digital view for a display device (150) of the ion milling system.

3. The system according to claim 2, wherein the digital view illustrates the height of a protrusion of the sample relative to the edge of the mask.

4. The system according to one of the claims 2 or 3, wherein the system is configured to include a scale (70) for determining the height of a protrusion of the sample relative to the edge of the mask in the digital view.

5. The system according to one of the claims 1 to 4, wherein the system is configured to process the image data to determine, relative to the image data, at least one of a position or orientation of an edge of the sample and to store information on the position and/or orientation of the edge of the sample.

6. The system according to claim 5, wherein the system is configured to generate a digital view based on the information on the position and/or orientation of the edge of the mask and based on the information on the position and/or orientation of the edge of the sample, with an indicator (60) highlighting the position and/or orientation of the edge of the sample.

7. **The** system according to one of the claims 5 or 6, wherein the system is configured to determine a distance between the edge of the mask and the edge of the sample and to store information on the distance between the edge of the mask and the edge of the sample.

8. **The** system according to claim 7, wherein the system is configured to determine the distance between the edge of the mask and the edge of the sample based on a pixel distance between the edge of the mask and the edge of the sample in the image data and based on a zoom level of the optical imaging device.

9. **The** system according to one of the claims 5 to 8, wherein the system is configured to determine a mismatch between the orientation of the edge of the mask and the orientation of the edge of the sample and store information on the mismatch.

10. The system according to one of the claims 1 to 9, wherein the system is configured to use at least one of image segmentation and/or object detection to determine a position of the mask and/or the sample in the image data, and to determine the position and/or orientation of the edge of the mask and/or of the sample based on the position of the mask or sample in the image data,
and/or wherein the system is configured to use an edge detection algorithm and/or a contrast detection algorithm to determine at least one edge of at least one object shown in the image data, and to use the position of the mask and/or sample in the image data to select the edge as edge of the mask and/or sample, and/or to limit the edge detection algorithm and/or contrast detection algorithm to a portion of the image showing the edge of the mask or sample.

11. The system according to one of the claims 1 to 10, wherein the system is configured to control a positioning mechanism based on the stored information to change a relative position between the sample and the mask.

12. The system according to one of the claims 1 to 11, wherein the system is configured to update the digital view after a relative position and/or orientation between the sample and the mask is adjusted by the user or by a positioning mechanism.

13. An ion milling system (100) comprising the system (110) according to one of the claims 1 to 12, an optical imaging device (120) and a display device (150).

14. A method for an ion milling system, the method comprising:
obtaining (410) image data of an optical imaging device of the ion milling system, the image data showing a sample to be milled using the ion milling system and a mask at least partially shielding the sample;
processing (420) the image data to determine, relative to the image data, a position and orientation of an edge of the mask; and
storing (425) information on a position and/or orientation of the edge of the mask.

15. A computer program having a program code for performing the method according to claim 14 when the program is executed on a processor.
